# EUROPÄISCHE PATENTSCHRIFT

(11) **EP 1 463 394 B1**
(45) Veröffentlichungstag und Bekanntmachung des Hinweises auf die Patenterteilung: **28.09.2005**
(21) Anmeldenummer: 03012750.0
(22) Anmeldetag: 05.06.2003
(51) Int. Cl.: H05K 7/14

(54) **Steckbaugruppe zum Einstecken und Ausziehen in bzw. aus einem Baugruppenträger**
Plug module for insertion and removal in particular of a circuit board
Module enfichable pour l'insertion et l'extraction en particulier d'une carte de circuit imprimé

(30) Priorität: 24.03.2003 DE 10313119
(43) Veröffentlichungstag der Anmeldung: 29.09.2004
(73) Patentinhaber: Schroff GmbH, D-75334 Straubenhardt (DE)
(72) Erfinder: Joist, Michael, 76571 Gaggenau (DE)
(74) Vertreter: Durm, Frank

(56) Entgegenhaltungen:
- EP-A- 1 017 262
- WO-A-02/19786
- WO-A-96/42186
- US-A- 5 675 475
- US-A- 6 094 353
- US-A1- 2002 057 550

## Beschreibung

Die Erfindung betrifft eine Steckbaugruppe zum Einstecken und Ausziehen in bzw. aus einem Baugruppenträger, der wenigstens eine vordere Profilschiene aufweist. Die Steckbaugruppe umfaßt eine Leiterplatte, einen Schalter zur Aktiv-Passiv-Schaltung der Steckbaugruppe und einen im Frontbereich der Steckbaugruppe schwenkbar gelagerten Hebelziehgriff mit einem Griffarm.

Aus- und Einziehvorrichtungen zum Einstecken und Ausziehen von Steckbaugruppen in bzw. aus Baugruppenträgern sind seit langem bekannt. Zum Ein- und Ausziehen der Steckbaugruppen wurden in der Vergangenheit die unterschiedlichsten Hebel und Hebelziehgriffe entwickelt. Dabei stellt sich insbesondere das Problem, dass eine Steckbaugruppe erst dann aktiv geschaltet werden soll, wenn sie vollständig in den Baugruppenträger eingeschoben ist. Beim Herausziehen soll die Baugruppe passiv geschaltet sein, bevor der Ausziehvorgang beginnt. Auf diese Weise soll gewährleistet werden, dass nur stromlos geschaltete Baugruppen vom Bus des Baugruppenträgers getrennt bzw. an den Bus angekoppelt werden. Störungen des Baugruppenträgers oder Beeinflussungen anderer Steckbaugruppen durch das An- oder Abkoppeln einer unter Spannung befindlichen Steckbaugruppe werden so vermieden.

Aus der DE 41 05 948 C2 ist eine Baugruppeneinheit mit einem Hebel zum Einsetzen der Baugruppe in eine Aufnahme bekannt. An einem langen Hebelarm des Hebels ist ein Griffhebel schwenkbar gelagert. Ein federndes Rastmittel verrastet den Hebel bei vollständig eingesteckter Baugruppe. Die Verrastung wird gelöst durch Verschwenken des Griffhebels. Im Frontbereich der Steckbaugruppe ist eine Schaltvorrichtung angeordnet, die beim Einsetzen bzw. Ausziehen der Baugruppeneinheit durch den Hebel betätigt wird. Damit soll gewährleistet werden, dass die Spannungsversorgung der Baugruppeneinheit erst dann aktiviert wird, wenn alle Verbindungen zu den Steckverbindungsgegenstücken des Baugruppenträgers hergestellt sind. Da der Schaltvorgang durch den Hebel selbst ausgelöst wird, ist eine Entkopplung des Schaltens von der Bewegung der Steckbaugruppe nicht möglich. Insbesondere beim Einschieben der Steckbaugruppe erfolgt der Schaltvorgang gegen Ende der Einschubbewegung an einem undefinierten Punkt, also noch während der Bewegung der Steckbaugruppe.

Die DE 195 07 712 C1 offenbart eine Ein- und Ausziehvorrichtung für eine Steckbaugruppe, bei der in einem Haltebock ein Stößel zwecks Betätigung eines Mikroschalters angeordnet ist. Ein Schwenkhebel zum Ein- und Ausziehen ist aus zwei gegeneinander verschwenkbaren Teilhebeln ausgebildet, deren äußerer Hebel eine dem Stößel gegenüberstehende Schulter aufweist und deren innerer Hebel die Abdrückschulter zum Angreifen an eine Profilschiene des Baugruppenträgers trägt, wobei zwischen den beiden Hebeln eine Feder angeordnet ist. Diese Anordnung setzt zwingend einen Haltebock voraus, an dem sowohl der Schwenkhebel gelagert ist als auch der Stößel verschiebbar geführt wird. Als nachteilig erweist sich auch, dass der Mikroschalter von dem Hebel nur indirekt über den Stößel betätigt werden kann und zudem der Stößel nur eine kleine Fläche aufweist, die auf den Mikroschalter wirkt. Dies erfordert eine sehr genaue Positionierung der Elemente und die Einhaltung von geringen Fertigungstoleranzen bei der Herstellung und Montage.

Die EP 0 832 548 B1 offenbart ein Frontsystem einer Flachbaugruppe mit einem speziellen Eckstück, einem im Eckstück angeordneten Hebelziehgriff und einem Mikroschalter zur Aktiv-Passiv-Schaltung der Steckbaugruppe. Die Betätigung des auf der Leiterplatte angeordneten Mikroschalters wird durch ein mechanisches Tastenelement bewirkt, auf das der Hebelziehgriff drückt. Die gezeigte Anordnung setzt zwingend ein separates Eckstück zur Halterung des Hebels sowie des Tastenelements voraus. Die Wirkung des Hebels auf das Schaltelement der Steckbaugruppe wird nur über die Aktivierung des Tastenelements realisiert.

In der EP 1 017 262 A1 ist eine Steckbaugruppe für einen Baugruppenträger beschrieben, die über einen Ein- und Aushebelgriff betätigt wird. An dem Ein- und Aushebelgriff ist ein federbetätigter Riegel angebracht, der den Hebel verriegelt, sobald die Steckbaugruppe ihre hintere Endstellung erreicht hat. Der Riegel kann zusätzlich ein Schaltelement für eine Aktiv-Passiv-Schaltung der Steckbaugruppe betätigen. Das Niederdrücken des Riegels bewirkt eine Passivschaltung des Schaltelements, bevor der Hebel durch den Riegel freigegeben wird. Für eine Aktivschaltung des Schaltelements muss eine Verriegelung des Griffhebels stattgefunden haben. Da der Riegel beim Erreichen der Endstellung des Hebels automatisch einrastet, läßt sich keine eindeutige Trennung des Einsteckvorgangs der Steckbaugruppe von der Aktiv-Passiv-Schaltung erzielen.

Aus der EP 0 958 719 B1 ist ein Frontelement einer Leiterplatte mit einem Hebelziehgriff bekannt, welcher an der Ecke des Frontelements drehbar angebracht ist und einen Rastschieber zur Entriegelung des Hebelziehgriffs aufweist. Ein Schaltelement ist in das Frontelement derart integriert, dass ein Schaltbügel des Schaltelements durch den langen Hebelarm des Hebelziehgriffs betätigt werden kann. Nachteilig an dieser Konstruktion ist, dass sowohl der Hebelziehgriff als auch das Schaltelement an demselben Frontelement angeordnet sein müssen. Weiterhin erlaubt die Betätigung des Schalters durch den Hebelziehgriff keine eindeutige Trennung des Ein- und Aushebelvorgangs der Steckbaugruppe vom Schaltvorgang.

Ein Frontsystem einer Flachbaugruppe mit einem Eckstück, an dem ein Hebelziehgriff angebracht ist, ist aus EP 0 832 547 B1 bekannt. Der Hebelziehgriff weist Mittel zur Fixierung der jeweiligen Position des Hebelziehgriffs auf. Ein ebenfalls am Eckstück integriertes Schaltelement wird durch den Hebelziehgriff in dessen entsprechender Position betätigt. Nachteilig bei dieser Ausführung ist, dass der Hebelziehgriff direkt auf den Schalter wirkt und damit keine Entkopplung des Ein- und Ausziehvorgangs vom Schaltvorgang möglich ist. Darüber hinaus müssen sowohl der Hebelziehgriff als auch das Schaltelement beide am Eckstück angeordnet sein.

Die EP 1 245 139 A1 zeigt ein Betätigungselement für eine Flachbaugruppe, bei dem ein Betätigungshebel an einem Endstück drehbar gelagert ist. Der Betätigungshebel umfasst einen Verriegelungsschieber, der ein im Endstück integriertes Schaltelement zur Aktiv-Passiv-Schaltung der Flachbaugruppe betätigt. Der Verriegelungsschieber ist jedoch derart im Hebelziehgriff angeordnet, dass beim Einhebeln der Steckbaugruppe durch Drehen des Betätigungshebels eine exakte Entkopplung von Drehbewegung des Hebels und Schaltwirkung nicht sichergestellt werden kann.

Um ein reibungsloses Zusammenwirken von Baugruppenträgern, Steckbaugruppen und Hebeln verschiedener Hersteller zu gewährleisten, sind die Maße und Anordnungen der einzelnen Elemente teilweise genormt. Ein Industriestandard ist die Hot Swap Specification PICMG, deren Version 3.0 einen Hebel zum Ein- und Aushebeln einer Steckbaugruppe aus einem Baugruppenträger vorsieht. Der Hebel weist an seinem langen Hebelarm eine angeformte Klinke auf, die einen im Frontbereich der Steckbaugruppe angeordneten Schalter zur Aktiv-Passiv-Schaltung der Steckbaugruppe bei Erreichen einer Endposition des Hebels betätigt. Dieser Hebel ist in seinen Maßen deutlich schmaler als die bekannten Hebel mit Schaltfunktion. Nachteilig an diesem vorbekannten Hebel ist wiederum, dass der Ein- und Aushebelvorgang der Steckbaugruppe nicht zuverlässig von der Schaltfunktion getrennt werden kann.

Es stellt sich die Aufgabe, mit einfachen mechanischen Mitteln eine zuverlässige Entkopplung des Ein- und Ausziehvorgangs der Steckbaugruppe von der Aktiv-Passiv-Schaltung der Steckbaugruppe zu gewährleisten. Die Vorrichtung zum Ein- und Ausziehen der Steckbaugruppe muss darüber hinaus die in den Standards geforderten Maße einhalten.

Zur Lösung der Aufgabe wird von einer Steckbaugruppe zum Einstecken und Ausziehen in bzw. aus einem Baugruppenträger, der wenigstens eine vordere Profilschiene aufweist, ausgegangen. Die Steckbaugruppe hat eine Leiterplatte, einen Schalter zu Aktiv-Passiv-Schaltung der Steckbaugruppe und einen im Frontbereich der Steckbaugruppe schwenkbar gelagerten Hebelziehgriff mit einem Griffarm.

Gelöst wird die Aufgabe erfindungsgemäß dadurch, dass der Griffarm des Hebelziehgriffs einen schwenkbar angelenkten Schalthebel mit einer Schaltklinke trägt, durch welche bei vollständig eingesteckter Steckbaugruppe der Schalter betätigbar ist. Erst wenn die Steckbaugruppe vollständig in dem Baugruppenträger eingesteckt ist, kann der am Griffarm drehbar gelagerte Schalthebel seine Endposition erreichen und dabei mit seiner Schaltklinke den Schalter betätigen. Damit findet eine strikte Trennung zwischen dem Einhebelvorgang der Steckbaugruppe, der durch den Hebelziehgriff bewirkt wird, und dem Schaltvorgang der Aktiv-Passiv-Schaltung der Steckbaugruppe, welcher durch den Schalthebel vorgenommen wird, statt. Die klare Trennung des Schaltens vom Einstecken der Steckbaugruppe in den Baugruppenträger gewährleistet zuverlässig, dass die Steckbaugruppe immer erst nach vollständigem Einschieben aktiv geschaltet wird. Störungen des Bussystems des Baugruppenträgers, die durch das Ankoppeln aktivierter Steckbaugruppen erzeugt werden, werden so sicher vermieden.

Da der Schalter zu Aktiv-Passiv-Schaltung der Steckbaugruppe nur bei vollständig eingesteckter Steckbaugruppe durch den Schalthebel betätigbar ist, wird die Steckbaugruppe vor dem Herausziehen aus dem Baugruppenträger passiv geschaltet. Damit wird sichergestellt, dass keine aktivierte Steckbaugruppe vom Bussystem des Baugruppenträgers getrennt wird.

In einer bevorzugten Ausführungsform der Steckbaugruppe weist die Schaltklinke des Schalthebels eine Rastnase auf, die hinter einer Rastkante im Frontbereich der Steckbaugruppe einrastbar ist. Die Verrastung des Schalthebels führt dazu, dass ein unabsichtliches oder selbsttätiges Bewegen des Schalthebels ausgeschlossen ist. Die Verrastung des Schalthebels bei vollständig eingesteckter Steckbaugruppe führt ferner dazu, dass zusätzlich auch der Hebelziehgriff verriegelt wird. Ein Herausziehen der Steckbaugruppe aus dem Baugruppenträger ist also erst nach Lösen der Verrastung und Entriegelung des Hebelziehgriffs möglich. Die Verrastung des Schalthebels wird dadurch gelöst, dass die Rastnase des Schalthebels hinter der Rastkante hervorbewegt wird. Das Lösen der Verrastung kann mit der Aktiv-Passiv-Schaltung gekoppelt werden. In diesem Fall wird gleichzeitig mit der Entriegelung des Hebelziehgriffs die Aktiv-Passiv-Schaltung der Steckbaugruppe betätigt. Hierdurch wird sichergestellt, dass vor dem Herausziehen der Steckbaugruppe aus dem Baugruppenträger eine Passiv-schaltung der Steckbaugruppe stattfindet. Die Rastkante, hinter der die Rastnase einrastet, kann beispielsweise direkt auf der Leiterplatte angeordnet sein.

Vorteilhafterweise weist die Steckbaugruppe eine Frontplatte mit einer Aussparung auf. Durch diese Aussparung in der Frontplatte greift die Schaltklinke des Schalthebels hindurch. Eine Kante der Aussparung bildet dabei die Rastkante, hinter die die Rastnase der Schaltklinke einrastet. Die Frontplatte schließt die Steckbaugruppe im Frontbereich ab und schützt sie vor Beschädigungen und Verschmutzungen. Der ebenfalls im Frontbereich angeordnete Hebelziehgriff wird während des Einschiebens bzw. Einhebelns der Steckbaugruppe in Richtung zur Frontplatte hin verschwenkt, so dass die Schaltklinke des Schalthebels durch die Aussparung der Frontplatte hindurch ins Innere der Steckbaugruppe ragt. Der hinter der Frontplatte angeordnete Schalter bleibt dabei durch die Schaltklinke betätigbar, sobald sich der Schalthebel in seiner Endposition befindet und die Steckbaugruppe vollständig in den Baugruppenträger eingesteckt ist. Die Frontplatte mit Aussparung stellt also einen Schutz für die Steckbaugruppe dar, ohne dass dadurch die Trennung von Ein- bzw. Ausziehvorgang der Steckbaugruppe und Aktiv-Passiv-Schaltung aufgehoben wird. Die Frontplatte kann an ihrem unteren Ende zusätzlich einen Ausschnitt aufweisen, der den unteren Bereich des Hebelziehgriffs ausspart und umformt.

Vorzugsweise weist die Schaltklinke des Schalthebels an ihrem freien Ende eine Schaltfläche auf, die auf den Schalter zur Aktiv-Passiv-Schaltung der Steckbaugruppe einwirkt. Die vorzugsweise ebene Schaltfläche der Schaltklinke kann mit einer Schalttaste am Schalter korrespondieren, so dass die Kraftwirkung der Schaltklinke auf den Schalter verbessert wird. Eine derartige Ausführung erweist sich gerade beim Einsatz von Mikroschaltern als vorteilhaft, da hier die Schalttaste entsprechend klein ausgebildet ist. Die zum Schalter korrespondierende Schaltfläche kann dann ebenfalls minimiert werden, so dass auch bei eingeschränkten Platzverhältnissen innerhalb der Steckbaugruppe eine optimale Schaltbewegung erzeugt wird.

Alternativ kann die Schaltklinke an ihrem freien Ende eine Schaltnocke aufweisen, die auf den Schalter drückt. Diese Ausführung erweist sich dann als vorteilhaft, wenn der Schalter mit seiner Schalttaste in Richtung Frontbereich der Steckbaugruppe weist. Durch die Schaltnocke kann eine besonders gute Anpassung der Schaltklinke an den Schalter erzielt werden. Die Schaltwirkung und die Kraftausübung der Schaltklinke auf den Schalter werden optimiert. Es ist auch denkbar, eine Schaltklinke mit Schaltfläche und Schaltnocke auszubilden, um so mehrere Schalter gleichzeitig oder nacheinander zu betätigen.

Der Schalter zur Aktiv-Passiv-Schaltung kann als elektrischer oder als optischer Schalter ausgebildet sein. Bei einem elektrischen Schalter wirkt die Schaltklinke des Schalthebels auf eine Schalttaste am Schalter und erzeugt ein elektrisches Signal, was direkt von der Elektronik der Steckbaugruppe verarbeitet werden kann. Bei Verwendung eines optischen Schalters wird zur Betätigung des Schalters entweder ein Lichtstrahl, der vom Schalter ausgesandt wird, von der Schaltklinke des Schalthebels reflektiert oder durch die Schaltklinke unterbrochen. In beiden Fällen wird die Änderung des optischen Signals in ein elektrisches Signal umgesetzt. Vorteilhaft kann ein optischer Schalter insbesondere dann eingesetzt werden, wenn das Lichtsignal beispielsweise über Lichtwellenleiter in einen entfernten Punkt der Steckbaugruppe übertragen werden soll.

In einer besonders vorteilhaften Ausführungsform weist der Schalthebel einen Betätigungsarm auf, der im Querschnitt U-förmig ausgebildet ist. Zwischen die beiden U-Schenkel ist der Griffarm des Hebelziehgriffs einschwenkbar. Der U-förmige Betätigungsarm umgreift also den Griffarm des Hebelziehgriffs teilweise und führt diesen zwischen seinen beiden U-Schenkeln. Dadurch wird die relative Bewegung des Schalthebels auf die Vorzugsrichtung beschränkt. Die Stabilität des Hebels wird vergrößert. Ein Verdrehen des Schalthebels gegen den Hebelziehgriff wird durch die U-förmige Führung vermieden. Hierdurch wird auch die Handhabbarkeit für den Benutzer optimiert. Als vorteilhaft erweist sich zudem, dass der U-förmige Betätigungsarm deutlich breiter ist als der Hebelziehgriff. Ein manuelles Betätigen des Betätigungsarms durch den Benutzer zum Lösen der Verrastung und zum Betätigen des Schalthebels bzw. des Hebelziehgriffs wird verbessert. Die Handhabbarkeit des Hebelziehgriffs wird dadurch komfortabler. Alternativ kann auch der Griffarm des Hebelziehgriffs U-förmig ausgebildet sein. Der Betätigungsarm wird dann zwischen den U-Schenkeln des Hebelziehgriffs geführt und schwenkt zwischen die beiden U-Schenkel ein. In dieser Ausführungsform kann der Betätigungsarm des Schalthebels zusätzlich T-förmig ausgebildet sein, so dass der T-Rücken eine breite Auflagefläche zur Führung durch den Benutzer bietet.

Bevorzugt wird der U-Rücken des Betätigungsarms zur Steckbaugruppe hin ausgerichtet. Damit ist der Betätigungsarm so angeordnet, dass der U-Rücken zwischen der Steckbaugruppe und dem Hebelziehgriff angeordnet ist. Der Bedienkomfort des Hebels wird dadurch verbessert. Im ersten Schritt der Bewegung des Schalthebels wird der Betätigungsarm in Richtung Hebelziehgriff gedrückt. Dies bewirkt gleichzeitig ein Lösen der Verrastung des Schalthebels. Im weiteren Verlauf der Betätigung des Betätigungsarms erreicht dieser den Hebelziehgriff. Nun wird die Kraft, die auf den Betätigungsarm ausgeübt wird, auf den Griffarm des Hebelziehgriffs übertragen und die Schwenkbewegung des Hebelziehgriffs beginnt. Damit wird die Steckbaugruppe aus dem Baugruppenträger herausgezogen. Unter ergonomischen Gesichtspunkten ist diese Ausführungsform optimal und wird vom Benutzer als besonders komfortabel empfunden.

In einer weiteren bevorzugten Ausführungsform der erfindungsgemäßen Steckbaugruppe ist am Schalthebel eine Federzunge angeformt. Gleichzeitig weist der Hebelziehgriff eine Nut auf, in die die Federzunge eingreift. Die in die Nut eingreifende Zunge gewährleistet das Festlegen einer Ruheposition des Schalthebels. Idealerweise ist diese Position so ausgerichtet, dass die Schaltklinke des Schalthebels mit ihrer Rastnase hinter der Rastkante einrastet. Dadurch findet bei vollständig eingesteckter Steckbaugruppe eine selbsttätige Verrastung des Schalthebels statt, so dass auch der Hebelziehgriff verriegelt ist. Gleichzeitig bleibt der Schalter, der durch die Schaltklinke betätigt wird, in seiner gewählten Einstellung. Ein zufälliges Schalten oder ein Entriegeln des Hebelziehgriffs ist ausgeschlossen. Die Beweglichkeit des Schalthebels kann durch eine Federzunge beschränkt werden, die zumindest etwas elastisch ist. In diesem Fall wird die Beweglichkeit des Schalthebels durch die Größe der korrespondierenden Nut im Hebelziehgriff bestimmt. Bevorzugt ist die Federzunge elastisch ausgebildet, so dass der Schalthebel ohne Überwindung einer allzu großen Kraft bewegt werden kann. Die elastische Federzunge hat darüber hinaus den Vorteil, dass der Schalthebel selbsttätig in seine Ruhestellung zurückbewegt wird.

Ein Ausführungsbeispiel der Erfindung wird nachstehend anhand der beigefügten Abbildungen näher erläutert. Es zeigen:
- Figuren 1a bis 1d: den vorderen Eckbereich einer Steckbaugruppe mit einem Hebelziehgriff und daran angelenktem Schalthebel, in unterschiedlichen Stellungen beim Herausziehen der Steckbaugruppe aus einem Baugruppenträger, jeweils in Seitenansicht;
- Figuren 2a bis 2b: eine alternative Ausführungsform des Schalthebels mit einer Schaltnocke, im Schnitt;
- Figur 3: eine perspektivische Darstellung des unteren Eckbereichs der Steckbaugruppe aus Figur 1;
- Figur 4: eine weitere perspektivische Darstellung des unteren Bereichs der Steckbaugruppe aus Figur 3;
- Figur 5: den Schalthebel aus Figur 3, perspektivisch;
- Figur 6: den Hebelziehgriff aus Figur 3, perspektivisch; und
- Figur 7: die Frontplatte der Steckbaugruppe aus Figur 3, perspektivisch.

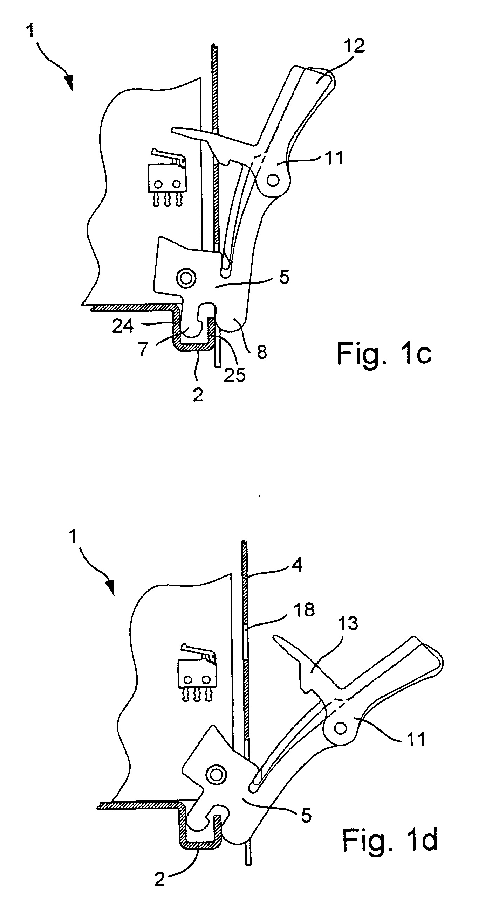

Die Figuren 1a -1d zeigen den unteren Eckbereich einer in einen Baugruppenträger eingesteckten Steckbaugruppe 1 während des Ausziehvorgangs. Vom Baugruppenträger ist hier lediglich eine untere Profilschiene 2 dargestellt.

Die Steckbaugruppe 1 in Fig. 1a umfasst eine Leiterplatte 3, eine Frontplatte 4 und einen an der Leiterplatte 3 drehbar angeordneten Hebelziehgriff 5. Im Eckbereich der Leiterplatte 3 ist ein Drehlager 6 angeordnet, um das der Hebelziehgriff 5 verschwenkbar ist. Der Hebelziehgriff 5 ist in seinem unteren Ende nahe des Drehlagers 6 als Sporn 7 ausgebildet. Der Sporn 7 greift bei vollständig in den Baugruppenträger eingeschobener Steckbaugruppe 1 in die Profilschiene 2 ein. Parallel zum Sporn 7, der Steckbaugruppe 1 abgewandt, weist der Hebelziehgriff 5 eine Abdrückschulter 8 auf. Von der Abdrückschulter 8 aus erstreckt sich ein Griffarm 9 nach oben. Der Griffarm 9 hat eine leicht gebogene Form, so dass sein freies Ende von der Steckbaugruppe weg geneigt ist. Etwa in der Mitte des Griffarms 9 ist seine der Steckbaugruppe 1 abgewandte Außenseite ausgebuchtet. In dem Bereich der Ausbuchtung ist ein Schwenklager 10 angeordnet, um das ein Schalthebel 11 verschwenkt werden kann.

Der L-förmig ausgebildete Schalthebel 11 umfaßt einen Betätigungsarm 12, der sich entlang des Griffarms 9 erstreckt, und eine Schaltklinke 13, die in Richtung Steckbaugruppe 1 weist.

Der Betätigungsarm 12 hat einen U-förmigen Querschnitt. Die beiden U-Schenkel 12a, 12b rahmen den Griffarm 9 ein, so dass beim Verschwenken des Schalthebels 11 der Griffarm 9 zwischen den beiden U-Schenkeln 12a, 12b geführt wird. An ihrem freien Ende weist die Schaltklinke 13 an ihrer Unterseite eine Schaltfläche 14 auf, die eben ausgebildet ist. Etwa in der Mitte der Schaltklinke 13 ist an ihrer Unterseite eine Rastnase 15 ausgebildet. Die Rastnase 15 ist zum freien Ende der Schaltklinke 13 hin abgeschrägt. Die dem Betätigungsarm 12 zugewandte Seite der Rastnase 15 verläuft rechtwinklig zur Unterseite der Schaltklinke 13. Von der Unterseite der Schaltklinke 13 aus erstreckt sich in Verlängerung des Betätigungsarms 12 eine Federzunge 16, die in etwa parallel zum Griffarm 9 des Hebelziehgriffs 5 verläuft. Die Federzunge 16 ist ungefähr so lang wie der Betätigungsarm 12. Die Federzunge 16 greift in eine Nut 17 des Hebelziehgriffs 5 ein, welche am unteren Ende des Griffarms 9 angeordnet ist.

Die Frontplatte 4 hat eine Aussparung 18, durch die die Schaltklinke 13 des Schalthebels 11 hindurchgreift, wenn der Griffarm 9 des Hebelziehgriffs in etwa parallel zur Steckbaugruppe 1 und zur Frontplatte 4 ausgerichtet ist. Gleichzeitig weist die Aussparung 18 eine Rastkante 19 auf, hinter der die Rastnase 15 der Schaltklinke 13 einrastet. Die angeschrägte Rastnase 15 kann über die Rastkante 19 geschoben werden. Die rechtwinklig angeordnete Seite der Rastnase 15 verhindert, dass die Rastnase 15 selbsttätig aus der Verrastung hinter der Rastkante 19 lösbar ist.

Im unteren Bereich der Frontplatte 4 ist ein Ausschnitt 20 vorgesehen. Der Ausschnitt 20 ist derart geformt, dass er den unteren Bereich des Hebelziehgriffs 5 umrahmt.

Im Frontbereich der Leiterplatte 3 ist ein Schalter 21 angeordnet. Der Schalter 21 weist eine Schalttaste 22 auf, die von der Schaltklinke 13 heruntergedrückt wird. Bei vollständig eingesteckter Steckbaugruppe 1 ist die Schalttaste 22 des Schalters 21 von der Schaltklinke 13 des Schalthebels 11 heruntergedrückt. Gleichzeitig ist die Rastnase 15 hinter der Rastkante 19 der Frontplatte 4 eingerastet. Die in die Nut 17 eingreifende Federzunge 16 sorgt für eine Vorspannung des Schalthebels 11, so dass der Betätigungsarm 12 vom Griffarm 9 weggedrückt und damit die Schaltklinke 13 nach unten gedrückt wird.

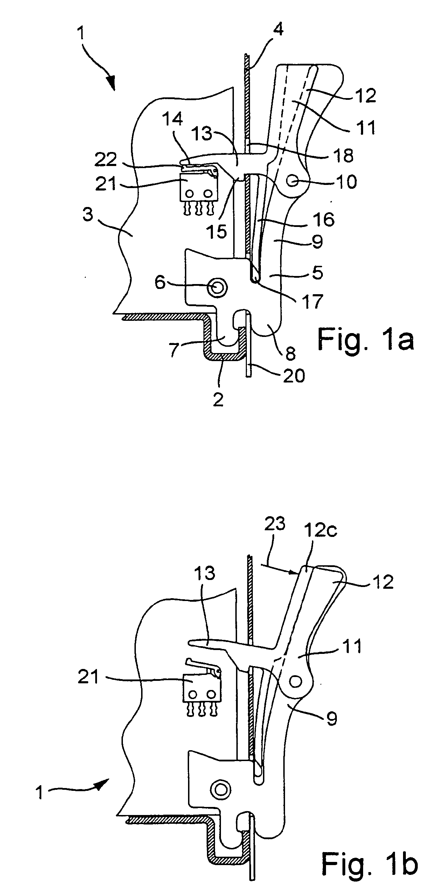

Bevor der Ausziehvorgang der Steckbaugruppe 1 aus dem Baugruppenträger heraus beginnen kann, muss zunächst die durch die Verrastung der Rastnase 15 mit der Rastkante 19 vorgenommene Verriegelung des Hebelziehgriffs 5 gelöst werden. Dazu wird der Betätigungsarm 12 in Richtung Griffarm 9 gedrückt. Dies ist durch den Pfeil 23 in der Fig. 1b dargestellt. Der Betätigungsarm 12 ist nun parallel zum Griffarm 9 ausgerichtet, wobei die Drehbewegung des Schalthebels 11 durch den U-Rücken 12c des Betätigungsarms 12 begrenzt wird. Die Bewegung des Betätigungsarms 12 wird gegen die Vorspannung der Federzunge 16 ausgeführt. Beim Verschwenken des Schalthebels 11 wird die Schaltklinke 13 vom Schalter 21 nach oben weg bewegt, so dass die Schalttaste 22 freigegeben wird und der Schalter 21 schaltet. Gleichzeitig wird die Verrastung der Rastnase 15 gelöst. Zu diesem Zeitpunkt wurde die Stellung des Hebelziehgriffs 5 noch nicht verändert, der Ausziehvorgang der Steckbaugruppe 1 hat noch nicht begonnen. Vielmehr ist die Steckbaugruppe 1 noch immer in ihrer Endposition, wohingegen die Aktiv-Passiv-Schaltung der Steckbaugruppe 1 durch den Schalter 21 schon stattgefunden hat. Die Steckbaugruppe 1 ist zu diesem Zeitpunkt also bereits passiv geschaltet.

Durch ein weiteres Verschwenken des Betätigungsarms 12 des Schalthebels 11 wird die auf den Schalthebel 11 wirkende Kraft auf den Hebelziehgriff 5 übertragen, so dass nun der Ausziehvorgang der Steckbaugruppe 1 aus dem Baugruppenträger heraus beginnen kann. Der Sporn 7 stösst in Fig. 1c mit seiner Vorderflanke gegen die linke Innenwand 24 der Profilschiene 2. Gleichzeitig drückt sich die Abdrückschulter 8 an der Außenwand 25 der Profilschiene 2 ab.

Fig. 1d zeigt schließlich die Stellung des Hebelziehgriffs 5 im weiteren Verlauf des Ausziehvorgangs. Die Steckbaugruppe 1 ist inzwischen ein Stück aus dem Baugruppenträger herausgezogen, so dass die Frontplatte 4 nicht mehr an der Profilschiene 2 anliegt. Die Schaltklinke 13 des Schalthebels 11 ist vollständig aus der Aussparung 18 der Frontplatte 4 herausbewegt worden.

Der Einsteckvorgang der Steckbaugruppe 1 in den Baugruppenträger wird nachvollziehbar, wenn die Figuren 1a bis 1d in umgekehrter Reihenfolge betrachtet werden.

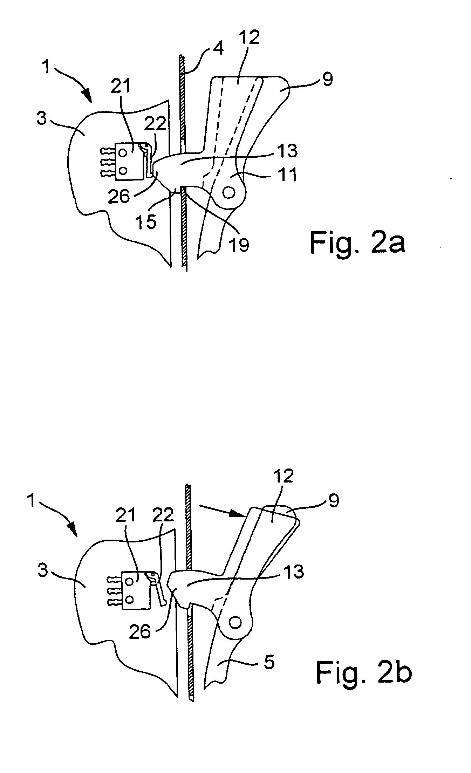

In den Figuren 2a und 2b ist eine alternative zweite Ausführungsform des Schalthebels 11 gezeigt. Die Schaltklinke 13 weist hier keine Schaltfläche mehr auf. Stattdessen ist am freien Ende eine Schaltnocke 26 angeformt. Die Verwendung eines solchen Schalthebels 11 mit einer Schaltnocke 26 ist vorteilhaft, wenn der Schalter 21 auf der Leiterplatte 3 so angeordnet ist, dass die Schalttaste 22 in Richtung Frontplatte 4 weist.

Fig. 2a zeigt einen Ausschnitt der vollständig in den Baugruppenträger eingesteckten Steckbaugruppe 1. Die Rastnase 15 ist hinter der Rastkante 19 der Frontplatte 4 verrastet. Die Schaltnocke 26 drückt die Schalttaste 22 des Schalters 21 herunter. Der Schalter 21 bleibt in seiner Schaltstellung.

Um nun die Steckbaugruppe 1 aus dem Baugruppenträger herauszubewegen, muss wiederum der Betätigungsarm 12 in Richtung Griffarm 9 bewegt werden, siehe Fig 2b. Damit löst sich die Verrastung. Gleichzeitig bzw. noch vor dem Lösen der Verrastung wird der Schalter 21 geschaltet. Auch bei dieser Ausführungsform mit Schaltnocke 26 wird vor dem Bewegen des Hebelziehgriffs 5 und damit vor Beginn des Ausziehens der Steckbaugruppe 1 aus dem Baugruppenträger die Aktiv-Passiv-Schaltung durch Schalten des Schalters 21 betätigt.

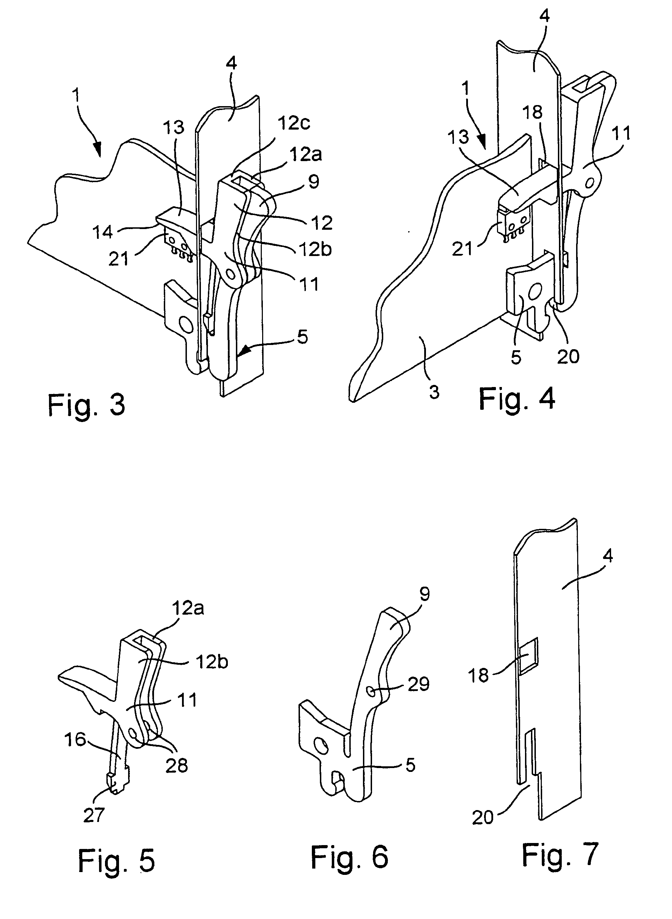

Fig. 3 zeigt den unteren Frontbereich der Steckbaugruppe 1 in perspektivischer Darstellung, von der Frontplatte 4 aus betrachtet. Der L-förmige Schalthebel 11 umfasst mit seinem U-förmig ausgebildeten Betätigungsarm 12 den Griffarm 9 des Hebelziehgriffs 5. Die beiden U-Schenkel 12a, 12b und der U-Rücken 12c umgreifen den Griffarm 9. Der Betätigungsarm 12 ist also breiter als der Griffarm 9. Der U-Rücken 12c, über den letztendlich die Kraft auf den Schalthebel 11 und mittelbar auch auf den Hebelziehgriff 5 ausgeübt wird, bietet eine größere Betätigungsfläche als der Griffarm 9, so dass die Handhabbarkeit des Hebels für den Benutzer verbessert wird. Ein Verschwenken des Schalthebels 11 gegen den Hebelziehgriff 5 wird durch den U-förmigen Betätigungsarm 12 begrenzt. Der U-Rücken 12c stößt an den Griffarm 9 an. Die vom Benutzer auf den Betätigungsarm 12 ausgeübte Kraft wird nun direkt auf den Hebelziehgriff 5 übertragen, so dass letztlich auch der Hebelziehgriff 5 verschwenkt wird. Die Schaltklinke 13 des Schalthebels 11 ist genauso breit wie der Betätigungsarm 12. Damit stellt der Schalthebel 11 eine der Schaltklinke 13 angepasste Schaltfläche 14 zur Verfügung, die in der Regel deutlich breiter ist als die Schalttaste 22 des Schalters 21, der hier als Mikroschalter ausgebildet ist. Auf diese Weise können Toleranzen bei der Anpassung des Schalters 21 an den Schalthebel 11 ausgeglichen werden.

Fig. 4 zeigt den unteren Eckbereich der Steckbaugruppe 1 in perspektivischer Darstellung, von der Steckbaugruppe 1 aus betrachtet. Deutlich sichtbar ist die durch die Aussparung 18 hindurchgreifende Schaltklinke 13 des Schalthebels 11, die auf den auf der Leiterplatte 3 angeordneten Schalter 21 drückt. Der untere Ausschnitt 20 der Frontplatte 4 ist so geformt, dass er gerade den unteren Bereich des Hebelziehgriffs 5 ausspart. Der Hebelziehgriffs 5 ragt durch die Frontplatte 4 hindurch.

Die perspektivische Darstellung des Schalthebels 11 in Fig. 5 lässt deutlich erkennen, dass die Federzunge 16 an ihrem unteren Ende kreuzförmig ausgebildet ist. Der Querbalken 27 greift bei zusammengesetztem Hebel gerade in die Nut 17 des Hebelziehgriffs 5 ein. Durch den Querbalken 27 wird gewährleistet, dass die Federzunge 16 auch dann in der Nut 17 verbleibt, wenn der Schalthebel 11 gegen den Hebelziehgriff 5 verdreht wird.

Am unteren Ende der beiden U-Schenkel 12a, 12b ist je eine Bohrung 28 vorgesehen, die miteinander fluchten. Sie nehmen das Schwenklager 10 auf, um dass der Schalthebel 11 verschwenkbar ist.

Fig. 6 zeigt detailliert den Hebelziehgriff 5. In der Mitte des Griffarms 9 ist eine Lagerbohrung 29 angeordnet, die mit den Bohrungen 28 des Schalthebels 11 korrespondieren.

Der untere Teil der Frontplatte 4 ist in Fig. 7 gezeigt. An der linken unteren Ecke der Frontplatte 4 ist der profilierte Ausschnitt 20 zu sehen, der im Wesentlichen an den Hebelziehgriff 5 angepasst ist. Die quadratische Aussparung 18 ist oberhalb des Ausschnitts 20 angeordnet.

### Zusammenstellung der Bezugszeichen

- 1: Steckbaugruppe
- 2: Profilschiene
- 3: Leiterplatte
- 4: Frontplatte
- 5: Hebelziehgriff
- 6: Drehlager
- 7: Sporn
- 8: Abdrückschulter
- 9: Griffarm
- 10: Schwenklager
- 11: Schalthebel
- 12: Betätigungsarm
- 12a: U-Schenkel
- 12b: U-Schenkel
- 12c: U-Rücken
- 13: Schaltklinke
- 14: Schaltfläche
- 15: Rastnase
- 16: Federzunge
- 17: Nut
- 18: Aussparung
- 19: Rastkante
- 20: Ausschnitt
- 21: Schalter
- 22: Schalttaste
- 23: Pfeil
- 24: Innenwand (von 2)
- 25: Außenwand (von 2)
- 26: Schaltnocke
- 27: Querbalken
- 28: Bohrung
- 29: Lagerbohrung

## Patentansprüche

1. Steckbaugruppe zum Einstecken und Ausziehen in bzw. aus einem Baugruppenträger, der wenigstens eine vordere Profilschiene aufweist, mit
- einer Leiterplatte,
- einem Schalter zur Aktiv-Passiv-Schaltung der Steckbaugruppe, und
- einem im Frontbereich der Steckbaugruppe schwenkbar gelagerten Hebelziehgriff mit einem Griffarm,
**dadurch gekennzeichnet, dass** der Griffarm (9) des Hebelziehgriffs (5) einen drehbar angelenkten Schalthebel (11) mit einer Schaltklinke (13) trägt, welche bei vollständig eingesteckter Steckbaugruppe (1) den Schalter (21) betätigt.

2. Steckbaugruppe nach Anspruch 1, **dadurch gekennzeichnet, dass** die Schaltklinke (13) des Schalthebels (11) eine Rastnase (15) aufweist, die hinter einer Rastkante (19) im Frontbereich der Steckbaugruppe (1) einrastbar ist.

3. Steckbaugruppe nach Anspruch 2, **gekennzeichnet durch** eine Frontplatte (4) mit einer Aussparung (18), welche die Rastkante (19) bildet und **durch** welche die Schaltklinke (13) hindurchgreift.

4. Steckbaugruppe nach einem der Ansprüche 1 bis 3, **dadurch gekennzeichnet, dass** die Schaltklinke (13) an ihrem freien Ende eine Schaltfläche (14) aufweist, die auf den Schalter (21) einwirkt.

5. Steckbaugruppe nach einem der Ansprüche 1 bis 3, **dadurch gekennzeichnet, dass** die Schaltklinke (13) an ihrem freien Ende eine Schaltnocke (26) aufweist, die auf den Schalter (21) drückt.

6. Steckbaugruppe nach einem der Ansprüche 1 bis 5, **dadurch gekennzeichnet, dass** der Schalter (21) als elektrischer oder optischer Schalter ausgebildet ist.

7. Steckbaugruppe nach einem der Ansprüche 1 bis 6, **dadurch gekennzeichnet, dass** der Schalthebel (11) einen im Querschnitt U-förmigen Betätigungsarm (12) hat, zwischen dessen U-Schenkeln (12a, 12b) der Griffarm (9) des Hebelziehgriffs (5) einschwenkbar ist.

8. Steckbaugruppe nach Anspruch 8, **dadurch gekennzeichnet, dass** der U-Rücken (12c) des Betätigungsarms (12) zur Steckbaugruppe (1) hin gerichtet ist.

9. Steckbaugruppe nach einem der Ansprüche 1 bis 8, **dadurch gekennzeichnet, dass** am Schalthebel (11) eine Federzunge (16) angeformt ist und der Hebelziehgriff (5) eine Nut (17) aufweist, in welche die Federzunge (16) eingreift.

## Claims

1. Plug-in module for insertion into and withdrawal from a module carrier which has at least one front profiled bar, with:
- a printed circuit board,
- a switch for active/passive switching of the plug-in module, and
- a pulling lever gripper pivotably mounted in a front area of the plug-in module and having a gripper arm,
**characterised in that** the gripper arm (9) of the pulling lever gripper (5) supports a rotatably articulated switching lever (11) with a switching pawl (13) which actuates the switch (21) when the plug-in module (1) is completely inserted.

2. Plug-in module as claimed in Claim 1, **characterised in that** the switching pawl (13) of the switching lever (11) has a detent (15) which can engage behind a detent edge (19) in the front region of the plug-in module (1).

3. Plug-in module as claimed in Claim 2, **characterised by** a front plate (4) with a cut-out (18) which forms the detent edge (19) and through which the switching pawl (13) engages.

4. Plug-in module as claimed in any one of Claims 1 to 3, **characterised in that** the switching pawl (13) has on its free end a switching face (14) which acts on the switch (21).

5. Plug-in module as claimed in any one of Claims 1 to 3, **characterised in that** the switching pawl (13) has on its free end a switching cam (26) which presses on the switch (21).

6. Plug-in module as claimed in any one of Claims 1 to 5, **characterised in that** the switch (21) is constructed as an electrical or optical switch.

7. Plug-in module as claimed in any one of Claims 1 to 6, **characterised in that** the switching lever (11) has an actuating arm (12) of U-shaped cross-section, wherein the gripper arm (9) of the pulling lever gripper (5) can be pivoted in between the arms of the U (12a, 12b) of the actuating arm.

8. Plug-in module as claimed in Claim 8, **characterised in that** the back of the U (12c) of the actuating arm (12) is directed towards the plug-in module (1).

9. Plug-in module as claimed in any one of Claims 1 to 8, **characterised in that** a spring tongue (16) is formed on the switching lever (11) and the pulling lever gripper (5) has a groove (17) in which the spring tongue (16) engages.

## Revendications

1. Module enfichable pour l'insertion et le retrait et d'un châssis qui présente au moins un rail profilé avant, comprenant
- une carte imprimée,
- un interrupteur pour la commutation active-passive du module enfichable, et
- une poignée de traction à levier avec un bras de prise montée pivotante dans la zone frontale du module enfichable,
**caractérisé en ce que** le bras de prise (9) de la poignée de traction à levier (5) porte un levier de commutation (11) articulé tournant avec un cliquet de commutation (13), qui actionne l'interrapteur (21) en position d'insertion totale du module enfichable (1).

2. Module enfichable suivant la revendication 1, **caractérisé en ce que** le cliquet de commutation (13) du levier (11) présente un ergot d'encliqietage (15), qui peut s'enclencher derrière un bord d'encliquetage (19) dans la zone frontale du module enfichable (1).

3. Module enfichable suivant la revendication 2, **caractérisé par** une plaque frontale (4) ayant un évidement (18) qui forme le bord d'encliquetage (19) et au travers duquel pénètre le cliquet de commutation (13).

4. Module enfichable suivant l'une des revendications 1 à 3, **caractérisé en ce que** le cliquet de commutation (13) présente à son extrémité libre une surface de commutation (14) qui agit sur l'interxupteur (21).

5. Module enfichable suivant l'une des revendications 1 à 3, **caractérisé en ce que** le cliquet de commutation (13) présente à son extrémité libre une came de commutation (26) qui presse sur l'interrupteur (21).

6. Module enfichable suivant l'une des revendications 1 à 5, **caractérisé en ce que** l'interrupteur (21) est réalisé sous forme d'interrupteur électrique ou optique.

7. Module enfichable suivant l'une des revendications 1 à 6, **caractérisé en ce que** le levier de commutation (11) a un bras de commande (12) en forme de U en section transversale, entre les branches du U duquel (12a, 12b) peut pivoter le bras de prise (2) de la poignée de traction à levier (5).

8. Module enfichable suivant la revendication 6, **caractérisé en ce que** le dos du U (12c) du bras de commande (12) est orienté en direction du module enfichable (1).

9. Module enfichable suivant l'une des revendications 1 à 8, **caractérisé en ce qu'**une languette élastique (16) est conformée sur le levier de commutation (11) et que la poignée de traction à levier (5) présente une gorge (17) dans laquelle s'engage la languette élastique (1).
